(19) Europäisches Patentamt
European Patent Office
Office européen des brevets

(11) **EP 3 308 442 B1**

(12) **EUROPÄISCHE PATENTSCHRIFT**

(45) Veröffentlichungstag und Bekanntmachung des Hinweises auf die Patenterteilung:
**24.08.2022   Patentblatt 2022/34**

(21) Anmeldenummer: **15783972.1**

(22) Anmeldetag: **02.10.2015**

(51) Internationale Patentklassifikation (IPC):
*H02J 3/38* (2006.01)      *G01R 31/40* (2020.01)
*H02M 7/48* (2007.01)      *H02J 3/00* (2006.01)
*H02M 1/00* (2006.01)

(52) Gemeinsame Patentklassifikation (CPC):
**H02J 3/38; G01R 31/40; H02M 7/48;** H02J 2203/20;
H02M 1/0012; Y02E 60/00; Y04S 40/20

(86) Internationale Anmeldenummer:
**PCT/EP2015/072837**

(87) Internationale Veröffentlichungsnummer:
**WO 2017/016617 (02.02.2017 Gazette 2017/05)**

(54) **VERFAHREN ZUR RECHNERGESTÜTZTEN PARAMETRIERUNG EINES UMRICHTERS IN EINEM STROMNETZ**

METHOD FOR COMPUTER-ASSISTED PARAMETERISATION OF A CONVERTER IN AN ELECTRICAL GRID

PROCÉDÉ DE PARAMÉTRAGE ASSISTÉ PAR ORDINATEUR D'UN CHANGEUR DE FRÉQUENCE DANS UN RÉSEAU ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.07.2015   DE 102015214535**

(43) Veröffentlichungstag der Anmeldung:
**18.04.2018   Patentblatt 2018/16**

(73) Patentinhaber: **Siemens Energy Global GmbH & Co. KG**
**81739 München (DE)**

(72) Erfinder:
• **HAMMOUDA, Manel**
  **80993 München (DE)**
• **MÜNZ, Ulrich**
  **Plainsboro, NJ 08536 (US)**
• **OBRADOVIC, Dragan**
  **85521 Ottobrunn (DE)**

(56) Entgegenhaltungen:
**US-A1- 2012 087 159      US-A1- 2014 132 075**

**Beschreibung**

Die Erfindung betrifft einen Umrichter, der parametriert ist mittels eines Verfahrens zur rechnergestützten Parametrierung des Umrichters in einem Stromnetz.

Zur elektrischen Energieerzeugung werden heutzutage vermehrt erneuerbare Energien, wie Photovoltaik und Windkraft, eingesetzt. Dies führt zu einer deutlichen Zunahme der hierzu benötigten Umrichter, mit denen die erneuerbaren Energien in ein Stromnetz eingespeist werden. Zum Beispiel können Windkraftanlagen und Solaranlagen bis zu 100 Umrichter mit individuellen, sehr schnellen Kontrollschleifen enthalten, um den in das Stromnetz zuzuführenden Strom entsprechend der verfügbaren Windkraft bzw. Photovoltaikleistung und den Netzbedingungen zu steuern. Dabei besteht das Problem, dass Resonanzen bzw. Schwingungen im Stromnetz auftreten, welche den Betrieb des Netzes beeinträchtigen.

Um solche Resonanzen zu vermeiden, ist es aus dem Stand der Technik bekannt, ein Simulationsmodell eines entsprechenden Umrichters zu erstellen und anschließend manuell Parameter des Umrichters zu variieren, bis mittels des Simulationsmodells zufriedenstellende Ergebnisse erreicht werden. Der Umrichter wird dann auf die Parameter eingestellt, mit denen gute Ergebnisse erzielt wurden. Nachteilhaft an diesem Ansatz ist, dass das manuelle Auffinden geeigneter Parameter sehr zeitaufwändig ist.

Aus der Schrift US 2012/0087159 A1 ist ein Umrichter in Form eines Wechselrichters bekannt, der einen definierten Ausgangsstrom liefert und bei dem nur eine geringe störende Rückwirkung auf die Energiequelle auftritt.

Aufgabe der Erfindung ist es, einen Umrichter anzugeben, der Parameter aufweist, die einen stabilen Betrieb des Stromnetzes gewährleisten.

Diese Aufgabe wird erfindungsgemäß gelöst durch einen Umrichter nach dem Patentanspruch 1.

In dem Verfahren wird in einem Schritt a) ein Ausgangsstrom des zu parametrierenden Umrichters modelliert. Dieser Ausgangsstrom wird von dem Umrichter in ein Wechselstromteilnetz des betrachteten Stromnetzes abgegeben. Die Modellierung des Ausgangsstroms erfolgt in Abhängigkeit von einem vorgegebenen (gewünschten) Referenzstrom und einer eingespeisten Störspannung basierend auf einem Modell, das den Betrieb des Umrichters beschreibt und eine Anzahl von Parametern des Umrichters umfasst.

In einem Schritt b) des Verfahrens wird ein vorgegebenes (erwünschtes) Folgeverhalten des Ausgangsstroms des Umrichters modelliert. Das vorgegebene Folgeverhalten gibt wieder, wie der Ausgangsstrom dem Referenzstrom folgt. Dabei ist das Folgeverhalten in einem ersten Frequenzintervall in der Umgebung einer vorgegebenen Nennfrequenz des Wechselstromteilnetzes (d.h. das erste Frequenzintervall umfasst die Nennfrequenz) derart festgelegt, dass der Ausgangsstrom dem Referenzstrom entspricht.

In einem Schritt c) des Verfahrens wird eine vorgegebene (erwünschte) Störunterdrückung modelliert, welche die Unterdrückung der eingespeisten Störspannung beschreibt. Dabei ist die Störunterdrückung derart ausgestaltet, dass der Einfluss der Störspannung auf den Ausgangsstrom in einem zweiten Frequenzintervall, das über der Nennfrequenz liegt, kleiner als eine vorgegebene Schwelle ist. Diese Schwelle kann durch einen Schwellwert der Störung repräsentiert werden, der nicht überschritten werden darf, da sonst der Einfluss der Störspannung zu groß wird. In einer bevorzugten Variante liegt die Nennfrequenz bei etwa 50 Hz. Ferner liegt in einer bevorzugten Variante das erste Frequenzintervall zwischen 0 und 300 Hz, wohingegen das zweite Frequenzintervall zwischen 100 Hz und 2 kHz liegt.

In einem Schritt d) des Verfahrens werden schließlich Werte für die Anzahl der Parameter des Umrichters durch Lösen eines Optimierungsproblems basierend auf einem Optimierungsziel bestimmt, welches dem Erreichen des oben definierten Folgeverhaltens und der oben definierten Störunterdrückung entspricht.

Das Verfahren weist den Vorteil auf, dass über eine geeignete Definition eines Optimierungsproblems und dessen Lösung automatisiert geeignete Parameter eines Umrichters ermittelt werden können, die einem gewünschten Folgeverhalten des Ausgangsstroms und einer gewünschten Störunterdrückung entsprechen. Auf diese Weise kann ein stabiler Betrieb des Stromnetzes unter Vermeidung von hochfrequenten Resonanzen sichergestellt werden, wenn in dem Stromnetz der Wechselrichter mit den in Schritt d) bestimmten Parameterwerten eingesetzt wird.

Das Verfahren kommt insbesondere zur Parametrierung eines Umrichters in der Form eines Wechselrichters zum Einsatz. Dieser Wechselrichter wandelt Gleichstrom aus einem Gleichstromteilnetz des Stromnetzes in den entsprechenden Wechselstrom des Wechselstromteilnetzes. Vorzugsweise ist der Wechselrichter Bestandteil einer regenerativen Energieerzeugungsanlage, wie z.B. einer Photovoltaikanlage oder einer Windkraftanlage.

In einer besonders bevorzugten Ausführungsform sind in dem Optimierungsziel des Verfahrens Gewichtungsfunktionen enthalten, welche das vorgegebene Folgeverhalten und die vorgegebene Störunterdrückung beschreiben.

In einer weiteren, besonders bevorzugten Ausführungsform erfolgt das Modellieren des Ausgangsstroms des Umrichters basierend auf einem linearen Modell, gemäß dem der Ausgangsstrom linear von dem Referenzstrom und der Störspannung unter Berücksichtigung einer Übertragungsfunktion abhängt. Hierdurch wird eine recheneffiziente Durchführung des Verfahrens gewährleistet.

Bei der Verwendung eines linearen Modells wird das Optimierungsziel in einer besonders bevorzugten Variante in der Form einer Minimierung einer $H_\infty$-Norm definiert, wobei die $H_\infty$-Norm von der Übertragungsfunktion sowie dem vorgegebenen Folgeverhalten und der vorgegebenen Störunterdrückung abhängt. Die $H_\infty$-Norm ist dem Fachmann hinlänglich bekannt und beschreibt den Maximalwert der Amplitude der Übertragungsfunktion an der imaginären Achse, d.h. in Abhängigkeit von der komplexen Frequenz $s=j\omega$.

In einer besonders bevorzugten Variante, bei der das Optimierungsziel die Minimierung der $H_\infty$-Norm ist, wird im Rahmen des Lösens des Optimierungsproblems diese Minimierung in ein äquivalentes Optimierungsziel mit bilinearen Matrizenungleichungen als Nebenbedingungen gewandelt. Diese Umwandlung kann in an sich bekannter Weise basierend auf den "Bounded Real Lemma" erfolgen. Das umgeformte äquivalente Optimierungsziel kann mit an sich bekannten Methoden, wie z.B. der sog. PK-Iteration, gelöst werden.

In dem Verfahren sind in dem Modell, das den Betrieb des Umrichters beschreibt, folgende Komponenten des Umrichters modelliert:

- eine PLL-Schaltung;
- ein dq0-Transformationsblock;
- ein Stromregler;
- ein PWM-Generator;
- ein Strommessfilter;
- ein Spannungsmessfilter;
- ein Leistungsteil;
- ein Netzfilter.

Die genannten Komponenten des Modells sind dem Fachmann hinlänglich bekannt. Es wird in dem Modell ferner das Wechselstromteilnetz modelliert. Diese Modellierung erfolgt in einer Variante der Erfindung basierend auf dem an sich bekannten Thevenin-Äquivalent.

In einer besonders bevorzugten Variante, welche die obigen Komponenten modelliert, werden das Strommessfilter und der Stromregler jeweils separat modelliert. Demgegenüber werden die PLL-Schaltung, das Spannungsmessfilter und der dq0-Transformationsblock gemeinsam modelliert. Ebenso werden das Leistungsteil, der PWM-Generator, das Netzfilter und das Wechselstromteilnetz gemeinsam modelliert.

In einer weiteren Variante umfasst die Anzahl der Parameter des Umrichters, für welche Werte in Schritt d) bestimmt werden, einen oder mehrere Parameter des Stromreglers, einen oder mehrere Parameter der PLL-Schaltung, einen oder mehrere Parameter des Spannungsmessfilters und einen oder mehrere Parameter des Strommessfilters. Der oder die Parameter des Stromreglers umfassen vorzugsweise einen Proportionalverstärkungsfaktor und einen Integralverstärkungsfaktor einer im Stromregler integrierten PI-Regelung (Proportional-Integral-Regelung). Ferner umfassen der oder die Parameter der PLL-Schaltung vorzugsweise einen Proportionalverstärkungsfaktor und einen Integralverstärkungsfaktor einer in der PLL-Schaltung integrierten PI-Regelung. Darüber hinaus umfassen der oder die Parameter des Strommessfilters vorzugsweise eine dem Strommessfilter zugeordnete Zeitkonstante und/oder der oder die Parameter des Spannungsmessfilters eine dem Spannungsmessfilter zugeordnete Zeitkonstante.

Neben dem oben beschriebenen Verfahren betrifft die Erfindung eine Vorrichtung zur rechnergestützten Parametrierung eines Umrichters in einem Stromnetz. Diese Vorrichtung umfasst eine Rechnereinheit, welche zur Durchführung des Verfahrens bzw. einer oder mehrerer bevorzugter Varianten des Verfahrens eingerichtet ist. Diese Vorrichtung kann in einem entsprechenden Stromnetz zur Parametrierung von Umrichtern integriert sein.

Die Erfindung betrifft darüber hinaus ein Computerprogrammprodukt mit einem auf einem maschinenlesbaren Träger gespeicherten Programmcode zur Durchführung des Verfahrens bzw. einer oder mehrerer bevorzugter Varianten des Verfahrens, wenn der Programmcode auf einem Computer ausgeführt wird.

Darüber hinaus umfasst die Erfindung ein Computerprogramm mit einem Programmcode zur Durchführung des Verfahrens bzw. einer oder mehrerer bevorzugter Varianten des Verfahrens, wenn der Programmcode auf einem Computer ausgeführt wird.

Ausführungsbeispiele der Erfindung werden nachfolgend anhand der beigefügten Figuren detailliert beschrieben.

Es zeigen:

Fig. 1    eine schematische Darstellung des Ablaufs einer Ausführungsform des als solches nicht beanspruchten Verfahrens; und

Fig. 2    eine schematische Darstellung eines Umrichters, der mit der Ausführungsform des Verfahrens aus Fig. 1 parametriert wird.

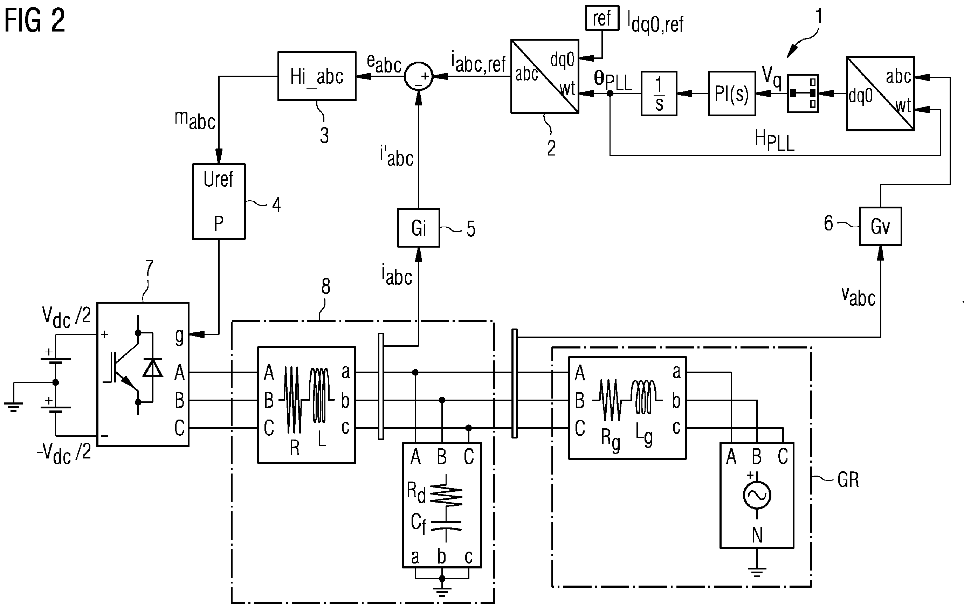

Im Folgenden wird eine Variante des Verfahrens basierend auf der Parametrierung des in Fig. 2 gezeigten Umrichters erläutert. Es handelt sich bei diesem Umrichter um einen Wechselrichter, der in einem Stromnetz Gleichstrom aus einem Gleichstromteilnetz in Wechselstrom eines Wechselstromteilnetzes wandelt.

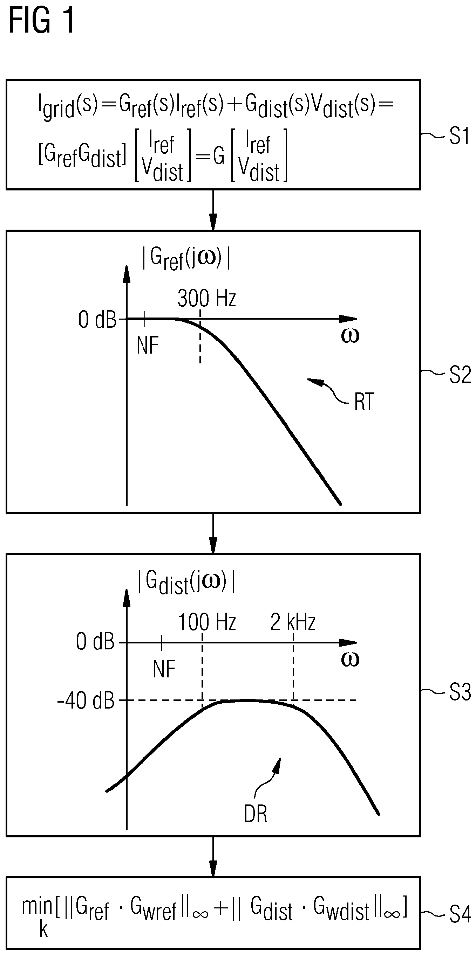

Bevor im Detail auf die Parametrierung des Wechselrichters der Fig. 2 eingegangen wird, erfolgt zunächst eine generische Erläuterung des hierfür verwendeten Verfahrens anhand von Fig. 1.

In einem Schritt S1 der Fig. 1 wird ein Ausgangsstrom $I_{grid}$ des Wechselrichters, der in das Wechselstromteilnetz abgegeben wird, in Abhängigkeit von einem vorgegebenen Soll-Referenzstrom $I_{ref}$ und einer eingespeisten Störspannung $V_{dist}$ modelliert. Die Modellierung ist durch eine entsprechende Gleichung in Schritt S1 angedeutet.

Wie sich aus der Gleichung des Schritts S1 ergibt, wird ein lineares Modell zur Beschreibung des Ausgangsstroms verwendet. Das heißt, in diesem Modell hängt der Ausgangsstrom linear von dem Referenzstrom und der Störspannung ab. Die lineare Abhängigkeit wird durch die beiden Übertragungsfunktionen $G_{ref}$ und $G_{dist}$ repräsentiert, welche als Vektor die Übertragungsfunktion $G$ repräsentieren. Dabei ist zu beachten, dass die Einträge $G_{ref}$ und $G_{dist}$ nicht nur vom komplexen Frequenzparameter s abhängen, sondern auch von weiteren Größen gemäß einem Modell, das den Betrieb des Umrichters beschreibt und weiter unten anhand von Fig. 2 näher erläutert wird. Die weiteren Größen umfassen Parameter des Umrichters, für welche im Rahmen des Verfahrens geeignete Werte ermittelt werden. Die Gesamtheit dieser Parameter wird im Folgenden auch mit dem Buchstaben k bezeichnet.

Gemäß den Schritten S2 und S3 der Fig. 1 erfolgt neben der Modellierung des Ausgangsstroms des Wechselrichters auch die Modellierung eines vorgegebenen Folgeverhaltens des Ausgangsstroms sowie eine Modellierung einer vorgegebenen Störunterdrückung. Schritt S2 zeigt dabei die Modellierung eines vorgegebenen Folgeverhaltens des Ausgangsstroms des Wechselrichters. Dieses Folgeverhalten gibt wieder, wie der Ausgangsstrom $I_{grid}$ des Wechselrichters dem Referenzstrom $I_{ref}$ folgen soll. In diesem Diagramm RT und analog auch in dem weiter unten beschriebenen Diagramm DR sind die entsprechenden Beträge der (gewünschten) Übertragungsfunktionen von $G_{ref}$ bzw. $G_{dist}$ in Dezibel in Abhängigkeit von der komplexen Frequenz s=jw angegeben. Das Folgeverhalten ist in Schritt S2 durch das Diagramm RT (RT = Reference Tracking) verdeutlicht. Mit NF ist dabei die Nennfrequenz des Wechselstromteilnetzes bezeichnet, welche im hier beschriebenen Ausführungsbeispiel bei 50 Hz liegt. Um einen stabilen Betrieb des Stromnetzes zu gewährleisten, soll der Ausgangsstrom des Wechselrichters entsprechend dem Diagramm RT im Frequenzintervall von 0 bis etwa 300 Hz dem Referenzstrom folgen.

Der Schritt S3 der Fig. 1 zeigt die Modellierung einer vorgegebenen Störunterdrückung, welche die Unterdrückung der eingespeisten Störspannung $V_{dist}$ beschreibt. Die Störunterdrückung ist durch das Diagramm DR (DR = Disturbance Rejection) angedeutet. Größere Werte in diesem Diagramm repräsentieren eine geringere Störunterdrückung. In dem Diagramm DR dürfen Resonanzen im Bereich zwischen 100 Hz und 2 kHz einen Wert von -40 dB nicht überschreiten.

Ziel des hier beschriebenen Verfahrens ist es nunmehr, die Parameter k des Wechselrichters so einzustellen, dass die Größen $G_{ref}$ und $G_{dist}$ das Folgeverhalten RT aus Schritt S2 bzw. die Störunterdrückung DR aus Schritt S3 erreichen. Um dies zu erreichen, wird ein Optimierungsproblem gelöst, das auf einer Minimierung der an sich bekannten $H_\infty$-Norm beruht. Dieses Optimierungsproblem ist in der Formel des Schritts S4 angegeben. Die $H_\infty$-Norm wird dabei durch das Symbol $\|\cdot\|_\infty$ repräsentiert. Diese Norm stellt den Maximalwert der Amplitude der entsprechenden Übertragungsfunktion in Abhängigkeit von der komplexen Frequenz $s = j\omega$ dar. In der Minimierung gemäß Schritt S4 sind Gewichtungsfunktionen $G_{wref}$ und $G_{wdist}$ enthalten. Gemäß diesen Gewichtungsfunktionen wird das gewünschte Folgeverhalten aus Schritt S2 bzw. die gewünschte Störunterdrückung aus Schritt S3 berücksichtigt. Vorzugsweise werden die Gewichtungsfunktionen $G_{wref}$ und $G_{wdist}$ aus den Inversen der in Schritt S2 und S3 modellierten Übertragungsfunktionen RT und DR berechnet. Um sicherzustellen, dass die Gewichtungsfunktionen kausal sind, d.h. mindestens genauso viele Pole wie Nullstellen aufweisen, müssen ggf. nach der Inversion noch zusätzliche Pole hinzugefügt werden. Diese Schritte sind dem Fachmann an sich bekannt.

Zur Lösung des Minimierungsproblems aus Schritt S4 wird in der hier beschriebenen Ausführungsform dieses Minimierungsproblem in ein äquivalentes Minimierungsproblem basierend auf dem an sich bekannten "Bounded Real Lemma" umgewandelt. Gemäß diesem Lemma kann das Optimierungsproblem aus Schritt S4 wie folgt geschrieben werden:

$$\min_{\gamma, P, k} \gamma$$

Unter den Nebenbedingungen:

$$P > 0$$

$$\begin{pmatrix} \overline{A}^T(k)P + P\overline{A}(k) & P\overline{B}(k) & \overline{C}^T(k) \\ \overline{B}^T(k)P & -\gamma I & \overline{D}^T(k) \\ \overline{C}(k) & \overline{D}(k) & -\gamma I \end{pmatrix} \prec 0$$

Das Symbol > repräsentiert die positiv Definitheit und das Symbol < die negativ Definitheit der entsprechenden Matrix, d.h. alle Eigenwerte der Matrix haben positiven bzw. negativen Realteil. Der Wert y repräsentiert eine obere Schranke für den Ausdruck der Minimierung aus Schritt S4. k sind wiederum die zu bestimmenden Parameter des Umrichters. P stellt eine positiv-definite Matrix dar (alle Eigenwerte in der rechten Halbebene). Die Matrizen $\overline{A}(k)$, $\overline{B}(k)$, $\overline{C}(k)$ und $\overline{D}(k)$ beschreiben das lineare Umrichtermodell im Zeitbereich. Man erhält diese Matrizen, indem die gewichtete Übertragungsfunktion $G_w(s,k) = [G_{ref}(s,k)G_{wref}(s)\ G_{dist}(s,k)G_{wdist}(s)]$ in ein entsprechendes Zustandsraummodell der folgenden Form umgerechnet wird:

$$\dot{x}(t) = \overline{A}(k)\,x(t) + \overline{B}(k) \begin{bmatrix} I_{ref}(t) \\ V_{dist}(t) \end{bmatrix}$$

$$I_{grid}(t) = \overline{C}(k)\,x(t) + \overline{D}(k) \begin{bmatrix} I_{ref}(t) \\ V_{dist}(t) \end{bmatrix}$$

Hierbei entsprechen $I_{grid}(t)$, $I_{ref}(t)$ und $V_{dist}(t)$ den Laplace-Rücktransformierten der oben genannten $I_{grid}(s)$, $I_{ref}(s)$ und $V_{dist}(s)$, wobei t die Zeit beschreibt. Diese Umformung ist dem Fachmann bekannt.

Das umgeformte Optimierungsproblem gemäß obiger Gleichung kann auf einfache Weise mit einem sog. PK-Algorithmus gelöst werden. Dabei wird das Optimierungsproblem abwechselnd für die Matrix **P** bei festgehaltenen Parametern **k** und für die Parameter **k** bei festgehaltener Matrix **P** so lange gelöst, bis **y** ausreichend klein ist.

Nachfolgend wird die Festlegung der Übertragungsfunktion **G** anhand des Wechselrichters der Fig. 2 erläutert. Der in Fig. 2 dargestellte Wechselrichter umfasst eine Vielzahl von Komponenten und wandelt eine Gleichspannung $V_{dc}$ aus einem Gleichstromnetz in eine entsprechende Wechselspannung für ein Wechselstromnetz, wobei das Wechselstromnetz in Fig. 2 mit GR bezeichnet ist. Die dargestellten Komponenten des Wechselrichters sind an sich bekannt, so dass diese Komponenten sowie die in Fig. 2 enthaltenen Bezeichnungen nicht im Detail erläutert werden. Der mit dem Wechselrichter erzeugte Wechselstrom ist dreiphasig, wobei diese Phasen in Fig. 2 durch die entsprechenden Buchstaben a/A, b/B und c/C repräsentiert werden. Im Folgenden wird ohne Beschränkung der Allgemeinheit immer auf die Phase a/A Bezug genommen.

Der Wechselrichter der Fig. 2 enthält eine PLL-Schaltung 1 (PLL = Phased Locked Loop), einen dq0-Transformationsblock 2, einen Stromregler 3, einen PWM-Generator 4, ein Strommessfilter 5, ein Spannungsmessfilter 6, ein Leistungsteil 7 sowie ein Netzfilter 8. Der Gleichstrom aus dem Gleichstromnetz gelangt über einen Zwischenkreis des Wechselrichters zu dem Leistungsteil 7 und wird dann mit den Komponenten des Wechselrichters in Wechselstrom gewandelt, der über das Netzfilter 8 (dargestellt durch zwei Blöcke) in das Wechselstromnetz GR (auch dargestellt durch zwei Blöcke) eingespeist wird. Das Wechselstromnetz wird basierend auf dem an sich bekannten Thevenin-Äquivalent modelliert.

Im Folgenden wird die in der hier beschriebenen Ausführungsform verwendete Modellierung der soeben beschriebenen Komponenten 1 bis 7 sowie des Wechselstromnetzes GR erläutert.

Die PLL-Schaltung 1, der dq0-Transformationsblock 2 und das Spannungsmessfilter 6 werden gemeinsam basierend auf folgender Gleichung modelliert:

$$\frac{i_{adist,ref}}{V_{adist}} = \frac{\left(\frac{1}{T_V}K_{p,PLL}s + \frac{1}{T_V}K_{i,PLL}\right)\frac{I_{dr}}{2}}{s^3 + \left(V_1 K_{p,PLL} + \frac{1}{T_V}\right)s^2 + \left(V_1 K_{i,PLL} + \frac{V_1}{T_V}K_{p,PLL}\right)s + \frac{V_1}{T_V}K_{i,PLL}} \tag{1}$$

Die Modellierung gemäß obiger Gleichung ist aus der Literatur bekannt und beispielsweise in Dokument [1] beschrieben.

Die Größen aus obiger Gleichung sind wie folgt definiert:

s ist der komplexe Frequenzparameter der Laplacetransformation;

$V_{adist}$ ist die eingespeiste Störspannung für die Phase a; $i_{adist,ref}$ ist der von der Störspannung $V_{adist}$ abhängige Anteil des Ausgangssignals des dq0-Transformationsblocks 2 und repräsentiert den Effekt der Störspannung auf den Referenzstrom;

$I_{dr}$ ist der Wirkanteil des Referenzstroms $I_{ref}$;

$K_{p,PLL}$ ist der Proportionalverstärkungsfaktor eines PI-Reglers in der PLL-Schaltung 1;

$K_{i,PLL}$ ist der Integralverstärkungsfaktor eines PI-Reglers in der PLL-Schaltung 1;

$V_1$ ist die Spannungsamplitude der Netzspannung im Wechselstromnetz GR;

$T_V$ ist die Zeitkonstante des Spannungsmessfilters 6.

Das Strommessfilter 5 wird durch folgende Gleichung modelliert:

$$\frac{i'_a}{i_a} = \frac{1/T_i}{s+1/T_i} \tag{2}$$

Die Größen in obiger Gleichung (sofern nicht zuvor definiert) sind wie folgt festgelegt:

$i_a$ ist das Eingangssignal des Strommessfilters 5 und entspricht dem Ausgangsstrom des Wechselrichters $I_{grid}$ für die Phase a, dieses Signal ergibt sich aus dem weiter unten dargestellten Modell (5a)/(5b) des Leistungsteils 7, des PWM-Generators 4, des Netzfilters 8 und des Wechselstromnetzes GR;

$i'_a$ ist das Ausgangssignal des Strommessfilters 5 und entspricht einem gefilterten Ausgangsstrom des Wechselrichters; $T_i$ ist die Zeitkonstante des Strommessfilters 5.

Der Ausgang des dq0-Transformationsblocks 2 und des Strommessfilters 5 werden in folgendes Fehlersignal $e_a$ durch einen entsprechenden Summationsblock gewandelt (t entspricht der Zeit):

$$e_a(t) = i_{a,ref}(t) - i'_a(t) = i_{a0,ref}(t) + i_{adist,ref}(t) - i'_a(t) \tag{3}$$

Hierbei ist $i_{adist,ref}(t)$ das Ausgangssignal des oben beschriebenen Modells (1) von PLL-Schaltung 1, dq0-Transformationsblock 2 und Spannungsmessfilter 6. $i_{a0,ref}(t)$ entspricht dem Referenzstrom $I_{ref}$ für die Phase a und $i'_a(t)$ ist das Ausgangssignal des oben beschriebenen Strommessfilters (2).

Der Stromregler 3 wird durch folgende Übertragungsfunktion modelliert:

$$\frac{m_a}{e_a} = \frac{K_{p,Hi}s^2 + K_{i,Hi}s + K_{p,Hi}\omega_1^2}{s^2 + \omega_1^2} \tag{4}$$

Die Größen in obiger Gleichung (sofern nicht zuvor definiert) sind wie folgt festgelegt:

$m_a$ ist das Ausgangssignal des Stromlegers 3;

$K_{p,Hi}$ ist der Proportionalverstärkungsfaktor einer PI-Regelung im Stromregler 3;

$K_{i,Hi}$ ist der Integralverstärkungsfaktor einer PI-Regelung im Stromregler 3;

$f_1$ ist die Nennfrequenz des Wechselstromnetzes GR, wobei $\omega_1 = 2\pi f_1$ gilt.

Das Leistungsteil 7, der PWM-Generator 4, das Netzfilter 8 und das Wechselstromnetz GR werden gemeinsam durch folgende Gleichungen modelliert:

$$\frac{i_a}{m_a} = \frac{\frac{1}{2}V_{dc}}{Ls+R+G_1(s)} \tag{5a}$$

$$\frac{i_a}{V_{adist}} = \frac{-G_2(s)}{Ls+R+G_1(s)} \tag{5b}$$

Die in den obigen beiden Gleichungen enthaltenen Größen (bis auf $G_1(s)$ und $G_2(s)$) wurden bereits zuvor definiert bzw. sind an den entsprechenden Stellen in Fig. 2 gekennzeichnet.

Die Übertragungsfunktionen $G_1(s)$ und $G_2(s)$ sind wie folgt festgelegt:

$$G_1(s) = \frac{R_g + sL_g}{1 + \dfrac{R_g + sL_g}{R_d + 1/sC_f}}$$

$$G_2(s) = \frac{1}{1 + \dfrac{R_g + sL_g}{R_d + 1/sC_f}}$$

Die in den obigen beiden Gleichungen enthaltenen Größen sind alle aus Fig. 2 ersichtlich.

Basierend auf der soeben beschriebenen Modellierung der Komponenten aus Fig. 2 können dann die Einträge $G_{ref}$ und $G_{dist}$ aus der Übertragungsfunktion G der Fig. 1 hergeleitet werden. Hierfür werden zunächst die Gleichungen (5a,b) zusammengefasst:

$$i_a = \frac{\frac{1}{2}V_{dc}}{Ls + R + G_1(s)} m_a + \frac{-G_2(s)}{Ls + R + G_1(s)} V_{adist}$$

Dann wird die Gleichung (4) für $m_a$ eingesetzt. Dabei wird für $e_a$ aus Gleichung (4) der Ausdruck aus Gleichung (3) verwendet. In das Ergebnis wird wiederum Gleichung (2) für $i'_a$ und Gleichung (1) für $i_{adist,ref}$ eingesetzt. Als Resultat erhält man eine Gleichung, die den Zusammenhang zwischen dem Referenzstrom $i_{a0,ref}$ der Phase a, der Störspannung $V_{adist}$ der Phase a und dem Ausgangsstrom $i_a$ der Phase a beschreibt. Analoge Gleichungen erhält man für die Phase b und c, so dass man insgesamt die Übertragungsfunktion G des Wechselrichters erhält. Diese Herleitung liegt im Rahmen von fachmännischem Handeln und wird deshalb nicht im Detail erläutert. Um die Minimierung gemäß Schritt S4 der Fig. 1 durchzuführen, werden noch die Gewichtungsfunktionen $G_{wref}$ und $G_{wdist}$ benötigt. Diese werden für den Wechselrichter aus Fig. 2 beispielhaft wie folgt gewählt:

$$G_{wref} = \frac{s + 10^5}{0.1s + 10^5}$$

$$G_{wdist} = 60 \frac{7500s + 1}{s^2 + 7500s + 1.471 \cdot 10^7}$$

Im Rahmen der Minimierung des Schritts S4 aus Fig. 1 werden folgende, der im Vorangegangenen beschriebenen Parameter (referenziert durch die Parameter k in Fig. 1) variiert:

$K_{p,Hi}, K_{i,Hi}, K_{p,PLL}, K_{i,PLL}, T_i, T_V$

Schließlich wird das Minimierungsproblem unter Verwendung des "Bounded Real Lemma" und eines PK-Algorithmus gelöst, wie bereits oben beschrieben wurde.

In der oben beschriebenen Modellierung wird davon ausgegangen, dass die Größen des Wechselstromnetzes GR konstant sind. In einer Modifikation des erfindungsgemäßen Verfahrens können jedoch auch variable Größen für das Stromnetz und insbesondere eine variable Netzimpedanz berücksichtigt werden. Dies kann durch eine geeignete Umformung des Optimierungsproblems unter Berücksichtigung von Unsicherheiten erreicht werden. Eine derartige Umformung liegt im Rahmen von fachmännischem Handeln.

Die im Vorangegangenen beschriebenen Ausführungsformen der Erfindung weisen eine Reihe von Vorteilen auf. Insbesondere wird ein stabiler Betrieb eines Stromnetzes durch geeignete Parametrierung eines Umrichters bzw. Wechselrichters erreicht. Dabei wird sichergestellt, dass durch den Wechselrichter der erwünschte Strom erzeugt wird und ferner hochfrequente Resonanzen geeignet unterdrückt werden. Der parametrierte Wechselrichter eignet sich insbesondere zum Einsatz in Stromnetzen, bei denen erneuerbare Energieerzeugungsanlagen verwendet werden. Ein entsprechender Wechselrichter wandelt dabei die von einer regenerierbaren Energieerzeugungsanlage (z.B. Photovoltaik- oder Windkraftanlage) erzeugte Gleichspannung in eine Wechselspannung zur Einspeisung in ein Wechselspannungsnetz.

Literaturverzeichnis

[1] M. Cespedes, J. Sun: Impedance Modeling and Analysis of Grid-Connected Voltage-Source Converters; Power Electronics, IEEE Transactions on; 29 (3), Seiten 1254-1261, 2014.

**Patentansprüche**

1. Umrichter, der parametriert ist mittels eines Verfahrens zur rechnergestützten Parametrierung des Umrichters in einem Stromnetz, umfassend folgende Schritte:

   a) Modellieren eines Ausgangsstroms ($I_{grid}$) des Umrichters, der in ein Wechselstromteilnetz (GR) des Stromnetzes abgegeben wird, in Abhängigkeit von einem vorgegebenen Referenzstrom ($I_{ref}$) und einer eingespeisten Störspannung ($V_{dist}$) basierend auf einem Modell, das den Betrieb des Umrichters beschreibt und eine Anzahl von Parametern (k) des Umrichters umfasst;
   b) Modellieren eines vorgegebenen Folgeverhaltens (RT) des Ausgangsstroms ($I_{grid}$) des Umrichters, wobei das vorgegebene Folgeverhalten (RT) wiedergibt, wie der Ausgangsstrom ($I_{grid}$) dem Referenzstrom ($I_{ref}$) folgt, und wobei in einem ersten Frequenzintervall in der Umgebung einer vorgegebenen Nennfrequenz (NF) des Wechselstromteilnetzes (GR) das Folgeverhalten (RT) derart festgelegt ist, dass der Ausgangsstrom ($I_{grid}$) dem Referenzstrom ($I_{ref}$) entspricht;
   c) Modellieren einer vorgegebenen Störunterdrückung (DR), welche die Unterdrückung der eingespeisten Störspannung ($V_{dist}$) beschreibt, wobei die Störunterdrückung (DR) derart ausgestaltet ist, dass der Einfluss der Störspannung ($V_{dist}$) auf den Ausgangsstrom ($I_{grid}$) in einem zweiten Frequenzintervall, das über der Nennfrequenz (NF) liegt, kleiner als eine vorgegebene Schwelle ist;
   d) Bestimmen von Werten für die Anzahl der Parameter (k) des Umrichters durch Lösen eines Optimierungsproblems basierend auf einem Optimierungsziel, welches dem Erreichen des Folgeverhaltens (RT) und der Störunterdrückung (DR) entspricht,

   wobei in dem Modell, das den Betrieb des Umrichters beschreibt, folgende Komponenten des Umrichters modelliert sind:

   - eine PLL-Schaltung (1);
   - ein dq0-Transformationsblock (2);
   - ein Stromregler (3);
   - ein PWM-Generator (4);
   - ein Strommessfilter (5);
   - ein Spannungsmessfilter (6);
   - ein Leistungsteil (7);
   - ein Netzfilter (8), und

   wobei in dem Modell, das den Betrieb des Umrichters beschreibt, das Wechselstromteilnetz (GR) modelliert wird.

2. Umrichter nach Anspruch 1, wobei in dem Optimierungsziel Gewichtungsfunktionen ($G_{wref}$, $G_{wdist}$) enthalten sind, welche das Folgeverhalten (RT) und die Störunterdrückung (DR) beschreiben.

3. Umrichter nach Anspruch 1 oder 2, wobei das Modellieren des Ausgangsstroms ($I_{grid}$) des Umrichters basierend auf einem linearen Modell erfolgt, gemäß dem der Ausgangsstrom ($I_{grid}$) linear von dem Referenzstrom ($I_{ref}$) und der Störspannung ($V_{dist}$) unter Berücksichtigung einer Übertragungsfunktion (G) abhängt.

4. Umrichter nach Anspruch 3, wobei das Optimierungsziel die Minimierung einer $H_\infty$-Norm ist, wobei die $H_\infty$-Norm

von der Übertragungsfunktion (G) sowie dem Folgeverhalten (RT) und der Störunterdrückung (DR) abhängt.

5. Umrichter nach Anspruch 4, wobei im Rahmen des Lösens des Optimierungsproblems die Minimierung der $H_\infty$-Norm in ein äquivalentes Optimierungsziel mit bilinearen Matrizenungleichungen als Nebenbedingungen gewandelt wird.

6. Umrichter nach einem der vorhergehenden Ansprüche, wobei das Wechselstromteilnetz (GR) modelliert wird basierend auf dem Thevenin-Äquivalent.

7. Umrichter nach einem der vorhergehenden Ansprüche, wobei in dem Modell, das den Betrieb des Umrichters beschreibt,

- das Strommessfilter (5) und der Stromregler (3) jeweils separat modelliert werden,
- die PLL-Schaltung (1), das Spannungsmessfilter (6) und der dq0-Transformationsblock (2) gemeinsam modelliert werden;
- das Leistungsteil (7), der PWM-Generator (4), das Netzfilter (8) und das Wechselstromteilnetz (GR) gemeinsam modelliert werden.

8. Umrichter nach einem der vorhergehenden Ansprüche, wobei die Anzahl von Parametern (k) des Umrichters, für welche Werte in Schritt d) bestimmt werden, einen oder mehrere Parameter des Stromreglers, einen oder mehrere Parameter der PLL-Schaltung, einen oder mehrere Parameter des Spannungsmessfilters und einen oder mehrere Parameter des Strommessfilters umfasst.

9. Umrichter nach Anspruch 8, wobei der oder die Parameter des Stromreglers (3) einen Proportionalverstärkungsfaktor und einen Integralverstärkungsfaktor einer PI-Regelung umfassen und/oder der oder die Parameter der PLL-Schaltung (1) einen Proportionalverstärkungsfaktor und einen Integralverstärkungsfaktor einer PI-Regelung umfassen und/oder der oder die Parameter des Strommessfilters (5) eine Zeitkonstante umfassen und/oder der oder die Parameter des Spannungsmessfilters (6) eine Zeitkonstante umfassen.

**Claims**

1. Converter, which is parameterized by means of a method for computer-aided parameterization of the converter in a power grid, comprising the following steps:

a) modelling an output current ($I_{grid}$) of the converter, which is delivered to an AC sub-grid (GR) of the power grid, as a function of a predefined reference current ($I_{ref}$) and an injected disturbance voltage ($V_{dist}$) based on a model that describes the operation of the converter and comprises a number of parameters (k) of the converter;
b) modelling a predefined reference tracking (RT) of the output current ($I_{grid}$) of the converter, wherein the predefined reference tracking (RT) reflects how the output current ($I_{grid}$) follows the reference current ($I_{ref}$), and wherein, in a first frequency interval close to a predefined nominal frequency (NF) of the AC sub-grid (GR), the reference tracking (RT) is set in such a way that the output current ($I_{grid}$) corresponds to the reference current ($I_{ref}$);
c) modelling a predefined disturbance rejection (DR) describing the rejection of the injected disturbance voltage ($V_{dist}$), wherein the disturbance rejection (DR) is configured in such a way that the influence of the disturbance voltage ($V_{dist}$) on the output current ($I_{grid}$) in a second frequency interval, which is above the nominal frequency (NF), is less than a predefined threshold;
d) determining values for the number of parameters (k) of the converter by solving an optimization problem based on an optimization aim consistent with achieving the reference tracking (RT) and the disturbance rejection (DR),

wherein the following components of the converter:

- a PLL circuit (1);
- a dq0 transformation block (2);
- a current controller (3);
- a PWM generator (4);
- a current measurement filter (5);
- a voltage measurement filter (6);
- a power section (7);

- a grid filter (8);

are modelled in the model describing the operation of the converter, and
wherein the AC sub-grid (GR) is modelled in the model describing the operation of the converter.

2. Converter according to Claim 1, wherein the optimization aim contains weighting functions ($G_{wref}$, $G_{wdist}$) describing the reference tracking (RT) and the disturbance rejection (DR).

3. Converter according to Claim 1 or 2, wherein the output current ($I_{grid}$) of the converter is modelled based on a linear model, according to which the output current ($I_{grid}$) is linearly dependent on the reference current ($I_{ref}$) and the disturbance voltage ($V_{dist}$) with due regard to a transfer function (G).

4. Converter according to Claim 3, wherein the optimization aim is the minimization of an $H_\infty$ norm, wherein the $H_\infty$ norm is dependent on the transfer function (G) and on the reference tracking (RT) and the disturbance rejection (DR).

5. Converter according to Claim 4, wherein solving the optimization problem involves the minimization of the $H_\infty$ norm being converted into an equivalent optimization aim using bilinear matrix inequalities as constraints.

6. Converter according to one of the preceding claims, wherein the AC sub-grid (GR) is modelled based on the Thevenin equivalent.

7. Converter according to one of the preceding claims, wherein

    - the current measurement filter (5) and the current controller (3) are each modelled separately;
    - the PLL circuit (1), the voltage measurement filter (6) and the dq0 transformation block (2) are modelled together;
    - the power section (7), the PWM generator (4), the grid filter (8) and the AC sub-grid (GR) are modelled together;

in the model describing the operation of the converter.

8. Converter according to one of the preceding claims, wherein the number of parameters (k) of the converter for which values are determined in step d) comprises one or more parameters of the current controller, one or more parameters of the PLL circuit, one or more parameters of the voltage measurement filter and one or more parameters of the current measurement filter.

9. Converter according to Claim 8, wherein the parameter or parameters of the current controller (3) comprise a proportional gain factor and an integral gain factor of a PI controller and/or the parameter or parameters of the PLL circuit (1) comprise a proportional gain factor and an integral gain factor of a PI controller and/or the parameter or parameters of the current measurement filter (5) comprise a time constant and/or the parameter or parameters of the voltage measurement filter (6) comprise a time constant.

**Revendications**

1. Changeur de fréquence, qui est paramétré au moyen d'un procédé de paramétrisation assisté par ordinateur du changeur de fréquence, dans un réseau de courant, comprenant les stades suivants :

    a) modélisation d'un courant ($I_{grid}$) de sortie du changeur de fréquence, qui est cédé à un réseau (GR) partiel de courant alternatif du réseau de courant, en fonction d'un courant ($I_{ref}$) de référence donné à l'avance et d'une tension ($V_{dist}$) perturbatrice appliquée, reposant sur un modèle, qui décrit le fonctionnement du changeur de fréquence et qui comprend un certain nombre de paramètre (k) du changeur de fréquence ;
    b) modélisation d'un comportement (RT) de suivi donné à l'avance du courant ($I_{grid}$) de sortie du changeur de fréquence, le comportement (RT) de suivi donné à l'avance reproduisant comment le courant ($I_{grid}$) de sortie suit le courant ($I_{ref}$) de référence, et dans lequel, dans un premier intervalle de fréquence au voisinage d'une fréquence (NF) nominale donnée à l'avance du réseau (GR) partiel de courant alternatif, le comportement (RT) de suivi est fixé de manière à ce que le courant ($I_{grid}$) de sortie corresponde au courant ($I_{ref}$) de référence ;
    c) modélisation d'une suppression (DR) donnée à l'avance de perturbation, qui décrit la suppression de la tension ($V_{dist}$) perturbatrice appliquée, la suppression (DR) de perturbation étant conformée de manière à ce que l'influence de la tension ($V_{dist}$) perturbatrice sur le courant ($I_{grid}$) de sortie dans un deuxième intervalle de fréquence, qui est au-dessus de la fréquence (NF) nominale, soit plus petite qu'un seuil donné à l'avance ;
d) détermination de valeurs pour le certain nombre de paramètres (k) du changeur de fréquence par résolution d'un problème d'optimisation reposant sur une cible d'optimisation, qui correspond à l'atteinte du comportement (RT) de suivi et de la suppression (DR) de perturbation,

dans lequel, dans le modèle, qui décrit le fonctionnement du changeur de fréquence, les composants suivant du changeur de fréquence sont modélisés :

- un circuit PLL (1) ;
- un bloc de transformation dq0 (2) ;
- un régleur de courant (3) ;
- un générateur PWM (4).
- un filtre de mesure du courant (5) ;
- un filtre de mesure de la tension (6) ;
- une partie de puissance (7) ;
- un filtre de réseau (8), et

dans lequel, dans le modèle, qui décrit le fonctionnement du changeur de fréquence, on modélise le réseau (GR) partiel de courant alternatif.

2. Changeur de fréquence suivant la revendication 1, dans lequel, dans la cible d'optimisation sont contenues des fonctions ($G_{wref}$, $G_{wist}$) de pondération, qui décrivent le comportement (RT) de suivi et la suppression (DR) de perturbation.

3. Changeur de fréquence suivant la revendication 1 ou 2, dans lequel la modélisation du courant ($I_{grid}$) de sortie du changeur de fréquence s'effectue sur la base d'un modèle linéaire, suivant lequel le courant ($I_{grid}$) de sortie dépend linéairement du courant ($I_{ref}$) de référence et de la tension ($V_{dist}$) perturbatrice, en tenant compte d'une fonction (G) de transfert.

4. Changeur de fréquence suivant la revendication 3, dans lequel la cible d'optimisation est la minimisation d'une norme $H_\infty$, dans lequel la norme $H_\infty$ dépend de la fonction (G) de transfert, ainsi que du comportement (RT) de suivi et de la suppression (DR) de perturbation.

5. Changeur de fréquence suivant la revendication 4, dans le cadre de la résolution du problème d'optimisation, on transforme la minimisation de la norme $H_\infty$ en une cible d'optimisation équivalente, ayant des inéquations matricielles bilinéaires comme conditions auxiliaires.

6. Changeur de fréquence suivant l'une des revendications précédentes, dans lequel on modélise le réseau (GR) partiel de courant alternatif sur la base de l'équivalent de Thevenin.

7. Changeur de fréquence suivant l'une des revendications précédentes, dans lequel, dans le modèle qui décrit le fonctionnement du changeur de fréquence,

- on modélise respectivement séparément le filtre de mesure de courant (5) et le régleur de courant (3),
- on modélise conjointement le circuit PLL (1), le filtre de mesure de tension (6) et le bloc de transformation dq0 (2),
- on modélise conjointement la partie de puissance (7), le générateur (4) PWM, le filtre de réseau (8) et le réseau (GR) partiel de courant alternatif.

8. Changeur de fréquence suivant l'une des revendications précédentes, dans lequel le nombre de paramètres (k) du changeur de fréquence, pour lesquels on détermine des valeurs au stade d), comprend un ou plusieurs paramètres du régleur de courant, un ou plusieurs paramètres du circuit PLL, un ou plusieurs paramètres du filtre de mesure de tension et un ou plusieurs paramètres du filtre de mesure de courant.

9. Changeur de fréquence suivant la revendication 8, dans lequel le ou les paramètres du régleur (3) de courant comprennent un facteur d'amplification proportionnel et un facteur d'amplification intégral d'une régulation PI et/ou le ou les paramètres du circuit PLL (1) comprennent un facteur d'amplification proportionnel et/ou un facteur d'amplification intégral d'une régulation PI et/ou le ou les paramètres du filtre de mesure de courant (5) comprennent une constante de temps et/ou le ou les paramètres du filtre de mesure de tension (6) comprennent une constante de temps.

# FIG 1

$$I_{grid}(s) = G_{ref}(s)I_{ref}(s) + G_{dist}(s)V_{dist}(s) = [G_{ref}G_{dist}] \begin{bmatrix} I_{ref} \\ V_{dist} \end{bmatrix} = G \begin{bmatrix} I_{ref} \\ V_{dist} \end{bmatrix}$$

~ S1

~ S2

~ S3

$$\min_{k} [\|G_{ref} \cdot G_{wref}\|_{\infty} + \|G_{dist} \cdot G_{wdist}\|_{\infty}]$$

~ S4

FIG 2

EP 3 308 442 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20120087159 A1

**In der Beschreibung aufgeführte Nicht-Patentliteratur**

- Impedance Modeling and Analysis of Grid-Connected Voltage-Source Converters. **M. CESPEDES ; J. SUN.** Power Electronics. IEEE Transactions, 2014, vol. 29, 1254-1261